(19) Europäisches Patentamt
European Patent Office
Office européen des brevets

(11) EP 1 976 039 B1

(12) **EUROPEAN PATENT SPECIFICATION**

(45) Date of publication and mention
of the grant of the patent:
**17.11.2010 Bulletin 2010/46**

(51) Int Cl.:
***H01L 41/24*** *(2006.01)*        ***C25D 13/14*** *(2006.01)*

(21) Application number: **08104575.9**

(22) Date of filing: **12.02.2004**

(54) **Method and apparatus to produce piezoelectric tubes**

Verfahren und Vorrichtung zur Herstellung piezoelektrischer Röhren

Méthode et appareil pour produire des tubes piézoélectriques

(84) Designated Contracting States:
**AT BE BG CH CY CZ DE DK EE ES FI FR GB GR HU IE IT LI LU MC NL PT RO SE SI SK TR**

(30) Priority: **01.07.2003 US 611401**

(43) Date of publication of application:
**01.10.2008 Bulletin 2008/40**

(62) Document number(s) of the earlier application(s) in accordance with Art. 76 EPC:
**04710575.4 / 1 639 657**

(73) Proprietor: **Nanyang Technological University Singapore 639798 (SG)**

(72) Inventors:
• **Ma, Jan**
  **610367 Singapore (SG)**
• **Boey, Yin Chiang**
  **288685 Singapore (SG)**

(74) Representative: **Finnie, Peter John**
**Gill Jennings & Every LLP**
**Broadgate House**
**7 Eldon Street**
**London EC2M 7LH (GB)**

(56) References cited:
JP-A- 8 336 967        US-A1- 2002 024 270
US-B1- 6 349 455

• MORITA T ET AL: "An ultrasonic micromotor using a bending cylindrical transducer based on PZT thin film" SENSORS AND ACTUATORS A, ELSEVIER SEQUOIA S.A., LAUSANNE, CH, vol. 50, no. 1-2, August 1995 (1995-08), pages 75-80, XP004303516 ISSN: 0924-4247
• MORITA T ET AL: "A CYLINDRICAL MICRO ULTRASONIC MOTOR USING PZT THIN FILM DEPOSITED BY SINGLE PROCESS HYDROTHERMAL METHOD (PHI 2.4MM, L = 10 mm STATOR TRANSDUCER)" IEEE TRANSACTIONS ON ULTRASONICS, FERROELECTRICS AND FREQUENCY CONTROL, IEEE SERVICE CENTER, PISCATAWAY, NJ, US, vol. 45, no. 5, September 1998 (1998-09), pages 1178-1187, XP000801799 ISSN: 0885-3010

EP 1 976 039 B1

**Description**

**Field of the Invention**

The invention relates to a method and apparatus for forming piezoelectric tubes, and in particular, to piezoelectric tubes suitable for use as transducers, as used for example in heart pumps, or the like.

**Description of the Related Art**

The reference to any prior art in this specification is not, and should not be taken as, an acknowledgement or any form of suggestion that the prior art forms part of the common general knowledge.

It is known in some practical applications of actuators and transducers, to use tubular piezoelectric components.

For example, a tubular transducer is a piezoelectric ceramic tube coated with electrodes both on the outer and inner surfaces. The outer electrode may be sectioned into quadrants along the longitudinal direction, with the inner electrode being grounded to allow movement of the electrode to be achieved by applying currents to selected quadrants of the outer electrode. Such configurations can be used in many situations, such as a tube scanner in scanning tunneling microscope (STM) and driving component in cylindrical ultrasonic motor.

A tube scanner, as proposed by Binning and Smith in "Single-tube three-dimensional scanner from scanning tunneling microscopy". Rev Sci. Instrum. 57, 1688-1989, operates to move in the x, y and z direction with sub-nanometer resolution by extension and contraction of the functional part under an applied electric field. This design offers advantages of good structural rigidity, easy calibration and high resonance frequency.

Currently, piezoelectric tubes of this form are produced using techniques such as injection molding, extrusion, and drilling holes through solid piezoelectric rods. However, these fabrication techniques typically suffer from a number of disadvantages. For example, it is usually difficult to ensure material uniformity using these techniques. Furthermore, thin-walled, small-sized tubes are usually difficult to produce due to constraints on the manipulation of the piezoelectric materials in this fashion.

In another example described by Higuchi et al in "An ultrasonic micromotor using a bending cylindrical transducer based on PZT thin film", Sensors and Actuators A, vol. 50, p.75-80, (1995), XP 4303516, a functional tubular transducer was fabricated using a hydrothermal method. As described, an ultrasonic motor is fabricated by depositing a lead zirconate titanate (PZT) thin film on a short cylindrical titanium pipe using the hydrothermal method.

In "A Cylindrical Micro Ultrasonic Motor Using PZT Thin Film Deposited by Single Process Hydrothermal Method ($\phi$ 2.4mm, L=10 mm Stator Transducer)", IEEE Transactions on Ultrasonics, Ferroelectrics, and Frequency Control, vol. 45, no.5, p. 1178-1187, (1998), XP 801799, Higuchi et al describe an improvement to the method, which uses only a single process instead of two linked processes.

The same techniques are described again by Higuchi et al in IEEE Ultrasonics Symposium, 549 (1994) and 671 (1998). JP8-336967 also discloses a similar technique for forming a piezoelectric actuator comprising piezoelectric tubes around a hollow metal rod, the tubes being produced by hydrothermal crystallisation.

Whilst this method allows for miniaturization without poling, it has the drawback of limited density (<3 g/cm$^3$) of the deposited film and the transducer size is also constrained by the titanium tube.

US2002/0024270A1 describes a method for forming a piezoelectric/electrostrictive film element at low temperature using electrophoretic deposition. The method includes preparing a suspension containing ceramic elements submerging a substrate into the suspension and performing electrophoretic deposition to form the piezoelectric/electrostrictive film element and thermally treating the element so produced. US6349455B1 describes a similar method.

As the development of small scale applications, and the use of piezoelectric tubes in integrated circuitry increases, there is a need for techniques of producing such miniaturized tubes accurately with high quality, and relatively cheaply.

**Summary of the invention**

According to a first aspect, the present invention provides a method of forming a piezoelectric tube, the method including the steps of: forming a suspension of ceramic particles in a fluid medium, positioning a rod in the fluid medium; depositing particles on the rod by electrophoresis; and, heat-treating the deposited particles to form the piezoelectric tube, wherein the method of heat-treating the deposited particles includes:

  (i) heating the deposited particles to a first predetermined temperature to thereby solidify the particles to a surface of the rod and burn the rod, to thereby leave a tube of solidified particles, the tube being closed at one end; and,
  (ii) heating the tube to a second predetermined temperature to thereby sinter the tube to form a dense ceramic tube.

Typically, the method of depositing the particles includes: positioning the rod in a container containing the suspension; connecting the rod to a first terminal of a power supply; connecting an electrode to a second terminal of the power supply, the electrode being in contact with the fluid medium; and using the power supply to apply a predetermined DC voltage to the electrode and the rod to thereby cause at least some of the particles to be deposited on the rod.

The container can be a conductive container adapted to act as the electrode. Alternatively, a separate electrode could be used.

If the container is the electrode, the container can be formed from at least one of stainless steel, copper, and another metal. Alternatively, the container can be formed form at least one of glass and plastic, the container being coated with at least one conductive layer.

The method generally further includes cutting off the closed end of the tube.

The second predetermined temperature is preferably higher than the first predetermined temperature. The first predetermined temperature can be between 500°C and 1000°C. The second predetermined temperature can be between 850°C and 1300°C.

The rod may be formed from graphite, although other materials may be used, including at least one of plastic and another material that can be burnt off at the first predetermined temperature, in which case the rod is coated with at least one conductive layer.

The method generally further includes using a magnetic stirrer to prevent sedimentation of the particles in the suspension.

The method of forming the suspension typically includes: dispersing the particles into a solvent to form the suspension and adjusting the pH value of said suspension to a predetermined pH value.

The solvent may be an organic solvent, such as at least one of ethanol and acetone. Alternatively, other solvents such as water may be used.

The method of dispersing the particles typically includes dispersing the particles ultrasonically.

The method can also include adding a stabilizer, such as ether glycol to the suspension.

In general, the particles are at least one of lead zirconate titanate; doped lead zirconate titanate; $BaTiO_3$; $0.95Pb(Zr_{0.52}Ti_{0.48})O_3 \cdot 0.03BiFeO_3 \cdot 0.02Ba(Cu_{0.5}W_{0.5})O_3$ +0.5wt% $MnO_2$ ; and other piezoelectric particles.

The method may further include applying metallic paste to the inner and outer surfaces of the piezoelectric tube; and, poling the piezoelectric tube to thereby form a transducer.

The poling conditions can include the application of an electrical field in the region of 2 - 4 kV/mm, for between 20 ~ 120 minutes duration and at temperature 100 to 150°C.

According to a second aspect, the present invention provides an apparatus for forming a piezoelectric tube, the apparatus including: a container for containing a suspension of ceramic particles in a fluid medium; a rod in contact with the fluid medium; an electrode in contact with the fluid medium; a power supply adapted to apply a predetermine voltage to the rod and the electrode to thereby deposit at least some of the particles on the rod in use; and, a heat source for heat-treating the deposited particles to form a piezoelectric tube, wherein the heat source is adapted to:

> (i) heat the deposited particles to a first predetermined temperature to thereby solidify the particles to a surface of the rod and burn off the rod, to thereby leave a tube of solidified particles, the tube being closed at one end; and,
> (ii) heat the tube to a second predetermined temperature to thereby sinter the tube to form a dense ceramic tube.

The container is preferably a conductive container adapted to act as the electrode, in which case the container can be formed from at least one of stainless steel, copper, and another metal. Alternatively, the container can be formed from at least one of glass and plastic, the container being coated with at least one conductive layer.

The second predetermined temperature is typically higher than the first predetermined temperature. The first predetermined temperature can be between 500 and 1200°C, with the second predetermined temperature being between 850 and 1300°C.

The rod may be formed from graphite. Alternatively, the rod may be formed from at least one of plastic and another material that can be burnt off at the first predetermined temperature, the rod being coated with at least one conductive layer.

The apparatus can also include a magnetic stirrer for stirring the fluid medium to prevent sedimentation of the particles in the suspension.

In general, the apparatus of the second aspect of the invention is adapted to perform the method of the first aspect.

**Brief Description of the Drawings**

Examples of the invention will now be described with reference to the accompanying drawings, in which:-

Figure 1 is a schematic diagram of an example of apparatus for producing piezoelectric tubes;
Figure 2 is an example of an alternative electrode arrangement for use in the apparatus of Figure 1;
Figure 3 is a schematic view of the rod of Figure 1 coated with a layer of ceramic particles; and,
Figure 4 is a cross sectional view of a piezoelectric tube produced using the apparatus of Figure 1;
Figure 5 is an SEM microstructure of the piezoelectric tube of Figure 4;
Figure 6 is an X-ray radiography photo for different tube sizes;
Figure 7A is a schematic side view of an example of a transducer that can be produced according to the invention;
Figure 7B is a schematic plan view of the transducer of Figure 7A;
Figure 8 is a schematic diagram of an example of apparatus for measuring the displacement of a transducer;
Figure 9 is a graph used in the determination of piezoelectric constant $d_{31}$ for a transducer;
Figures 10A and 10B are schematic diagrams of the coordinate system used for measuring the free-boundary end modes of transverse oscillation of a transducer;
Figure 11 is a graph showing the displacement response for a tube produced according to a first specific example;
Figure 12 is an example of the coordinate system used when measuring free-free end modes of oscillation of a transducer;
Figure 13 is a graph showing the bending displacement in response to a step voltage;
Figure 14 is a graph showing a comparison of calculated and measured end displacement of a tube produced according to the first specific example of Figure 7;
Figure 15 is a schematic plan view of a second example of a transducer that can be produced according to the invention;
Figure 16 is a cross sectional view of an example of a double layer piezoelectric tube;
Figure 17 is XRD pattern of the piezoelectric tube of Figure 16;
Figure 18 is an SEM microstructure of the piezoelectric tube of Figure 16;
Figure 19 is an example of the configuration of a double layered transducer;
Figure 20 is a graph showing the longitudinal displacement of a double layered transducer,
Figure 21 is a graph showing the bending displacement of a double layered transducer;
Figure 22 is a graph showing a comparison between the theoretical and measured bending displacement of a double layered transducer under the condition $V_2=0$;
Figure 23 is a graph showing a comparison between the theoretical and measured bending displacement of a double layered transducer under the condition $V_1=0$;
Figure 24 is a graph showing a comparison between the bending displacement of a single and double layered transducer under the condition $V_1=V_2=V$; and,
Figure 25 is a graph showing the variation in the bending displacement of a double layered transducer for a varying intermediate radius $r_2$.

## Detailed Description of the Preferred Embodiment

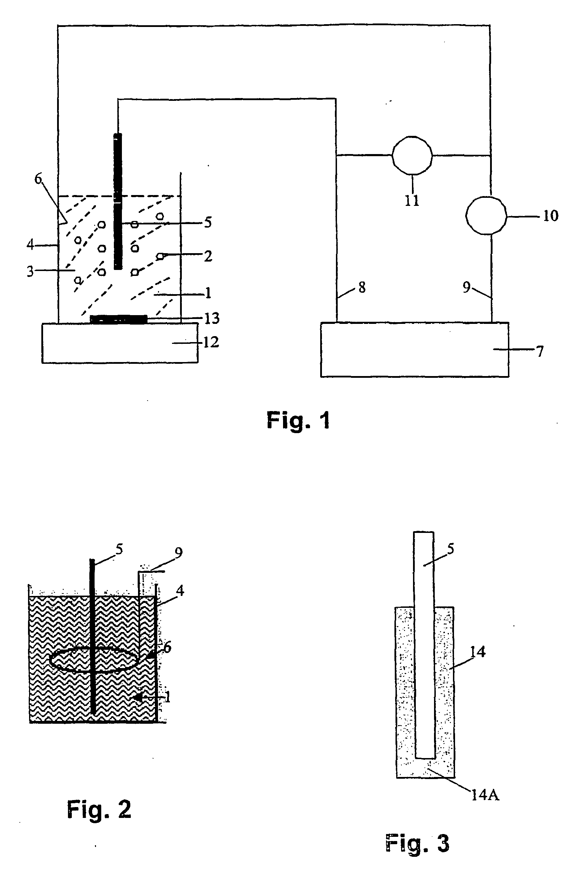

An example of apparatus for forming piezoelectric tubes is shown in Figure 1.

As shown the apparatus includes a container 4, adapted to hold a stable colloidal suspension 1, formed from a number of particles 2 held in suspension within a solvent 3. A rod 5 is adapted to be positioned within the fluid suspension 1, as shown. An electrode 6 is also provided, with the electrode 6 and the rod 5 being coupled to a power supply 7, via respective leads 8, 9.

Typically an ammeter 10 and a voltmeter 11 are provided to allow the current and voltage applied to the rod 5 and the electrode 6 to be measured.

Finally, the container 4 is positioned on a magnetic stirrer 12, which is adapted to cause rotation of a magnetic bar 13, positioned in the container 13 to allow the suspension to be stirred in use.

In this example, the container is formed from an electrically conductive material, and accordingly, the container 4 acts as the electrode 6. However, it is also possible to provide a separate electrode 6, as shown for example in Figure 2.

In use, the apparatus allows the particles to be deposited on the rod using electrophoretic deposition (EPD). The manner in which this may be achieved will now be described.

In particular, the particles 2, which are piezoelectric ceramic particles, such as lead zirconate titanate (PZT), doped lead zirconate titanate (PZT), $BaTiO_3$, or the like, are dispersed into the solvent 3 to form the suspension 1. The nature of the solvent will depend on the specific implementation, and the particles 2, although typically organic solvents, such as ethanol and acetone, are used. However alternative solvents, such as water, may also be used if appropriate.

Once the particles are suspended within the solvent, the pH value of the suspension is adjusted by adding either an acid or a base. Generally the pH value of the suspension is adjusted to be in the range between pH 4 to 5.

In order to avoid agglomeration of the particles, it is preferable for the particles 2 in the suspension 1 to be ultrasonically dispersed. Furthermore, stabilizers, such as ester glycol can be added to the suspension 1, before the suspension 1 is transfer into the container 4.

The container 4 is typically placed on the magnetic stirrer 12, with the magnetic bar 13 positioned in the bottom of the container 4, as shown. This allows the suspension 1 to be stirred, thereby helping to avoid sedimentation of the particles during the process.

The rod 5 is then connected to the power supply 7, using the lead 8 before being inserted into the suspension 1 to act as an electrode. Similarly the other electrode 6 is positioned in contact with the suspension 1. This is achieved either by inserting the electrode 6 into the container 4, as in the case of Figure 2, or simply by connecting the container 4 to the power supply 7 using the lead 9 in Figure 1.

In this latter case, the container 4 can be formed from stainless steel, copper, or any other metal that is sufficiently unreactive, so as not to impact on the EPD process. Alternatively, the container 4 can be formed from plastic/glass coated with one or more conductive layers.

Similarly, the rod 5 can be formed from graphite or plastic coated with one or more conductive layer or layers.

The particles held in suspension will hold a charge, the polarity of which depends on the pH level of the fluid medium. In this example, the particles have a positive charge because the pH level is acidic.

When the DC power supply 7 is activated, an electric potential is generated between the rod 5 and the electrode 6. In particular, the rod 5 is connected to the negative terminal of the power supply, so that the rod acts as a cathode and becomes negatively charged. Similarly the electrode 6 acts as the positively charged anode.

The particles having a positive charge are therefore attracted to the rod 5. In this regard, it is preferred that the electrode 6 surrounds the rod 5, so as to generate an even potential gradient extending radially outwardly from the rod 5. This ensures that the particles are attracted to the rod evenly from all directions.

Accordingly, the particles are attracted to, and hence become deposited evenly over the surface of the rod. Adjusting the voltage and current applied to the rod 5 and the electrode 6 can be used to control the thickness and quality of the deposited layer, as well as the rate of deposition, as will be appreciated by persons skilled in the art. Thus for example, increasing the current density or the voltage will lead to an increase in the rate of deposition.

After deposition, the rod 5 is coated with a layer of ceramic particles, as shown for example at 14 in Figure 3. The rod 5 is removed from the suspension 1 and dried in air for a predetermined time period, which will vary depending on factors, such as the thickness of the deposited layer.

At this point, if a dual layer tube is to be produced, once the deposits have been thoroughly dried, the outer surface of the deposited layer can be painted with a uniform layer of metallic paste, such as platinum paste. A second layer of deposition can be performed to produce a second ceramic layer.

It will be appreciated that this process may be repeated any number of times to form a multi-layered tube, with each layer being separated using appropriate intermediate electrodes. Thus, for a piezoelectric tube having N layers (where N≥2), there will be provided N-1 intermediate electrodes, with additional inner and outer electrodes being provided, as will be described in more detail below.

In any event, once the desired number of layers are provided, the dried rod 5 and particle layer 14 (it will be appreciated that a number of layers may be present, but only one will be described for clarity purposes) is then fired by heating in a furnace at a first temperature, to thereby solidify the particle layer 14, and burn away the rod 5, to thereby leave the particle layer 14 intact. The first temperature is typically between 500°C and 1200°C, and it will therefore be appreciated that the rod 5 must be made of material that can burn within this temperature range.

After the rod has been removed, the particle layer 14 forms a tube, having one closed, as shown at 14A in Figure 3.

The tube is then sintering at a second higher temperature to form a dense ceramic tube. This is typically performed at temperatures between 850°C and 1300°C, depending on factors such as the thickness of the particle layer 14.

The tube is then allowed to cool, before having the closed end removed, to thereby form a hollow tube open at both ends, as will be appreciated by persons skilled in the art

After poling, in which the piezoelectric tube is exposed to an electric field, the tube may be used as a transducer, an actuator, or the like. The poling conditions will vary depending on the intended use of the piezoelectric tube. Thus, for example, if the tube is to be used as a pump transducer, typical poling conditions will include the application of an electrical field in the region of 2 ~ 4 kV/mm, for between 20 ~ 120 minutes duration and at temperature 100 to 150°C. This may be performed in silicon oil.

First Specific Example

A specific example of the conditions used in the formation of a single layer piezoelectric transducer tube, suitable for use in an STM, or as a pump transducer, as described for example in the co-pending patent application entitled "Pump", (filed as serial no. 60/415844, attorney docket number DAVI190.001PRF filed October 02, 2002) will now be described.

In particular, in this example, the ceramic used to fabricate the transducer is a hard material with a composition of $0.95Pb(Zr_{0.52}Ti_{0.48})O_3$ $0.03BiFeO_3$ $0.02Ba(Cu_{0.5}W_{0.5})O_3$+ 0.5wt%$MnO_2$. This is formed by mixing raw oxide powders of PbO(>99.9%), $ZrO_2$(>99.9%), $TiO_2$(>99.99%), $BiO_3$(>99.99%), $Fe_2O_3$(>99%), BaO (>99%), CuO(>99.99%), $WO_2$ (>99%) and $MnO_2$(>99.99%) with the required stoichiometrical composition and then ball-milling the mixture for 24 hours. Due to the volatility of PbO during sintering, an additional 5% of PbO can be added into the raw powders. The mixed powders are then calcined at 750 °C for 2 hours. Finally, the calcined powders were ground by a planetary ball-milling machine at a speed of 150 rpm in ethanol for 8 hours. This process results in the ground powders having a mean particle size of 1.4 $\mu$m which can be determined using an acoustic particle sizer.

To prepare the piezoelectric suspension, a conductive container, whose diameter can be 40 to 100 mm, is used. 3 to 5 grams of the piezoelectric powder, $0.95Pb(Zr_{0.52}Ti_{0.48})O_3$·$0.03BiFeO_3$·$0.02Ba(Cu_{0.5}W_{0.5})O_3$+0.5wt%$MnO_2$. is mixed with 200 to 300 ml ethanol in the container. 2 to 5 drops of 5% $HNO_3$ is also added to adjust the pH value of the suspension.

The suspension is dispersed using an ultrasonic cleaner for 6 minutes, although longer time frames of 20 to 40 minutes may be used, to break up agglomerates. After dispersion, the piezoelectric suspension is ready for electrophoretic deposition (EPD).

In this example the powder concentration in the suspension is 50 g/l and the suspension pH is controlled to be 4 or 4.6 at room temperature. The suspension may also be stirred for 3 to 6 hours to further ensure the complete dissolution and dispersion of the powders in the medium.

In this example, the conductive container is used as the anode, with the rod 5 having a diameter of between 0.3 to 25mm, being used as the cathode.

The distance between the two electrodes is adjusted to between 20 to 50 mm. A DC voltage with the range of 10 to 100 V is applied between the container 4 and the rod 5, during which time the suspension is stirred with a magnetic stirrer 12 at a moderate speed to avoid the sedimentation of the powder particles.

Under these conditions, the process takes between 3 to 30 minutes to deposit a layer of particles on the conductive rod depending on the required thickness and applied voltage. Thus, at a higher voltage of 100V, a duration of 3 to 8 minutes may typically be used. After being thoroughly dried for 12 to 48 hours at ambient temperature, the deposited sample is heat-treated in a furnace to burn off the carbon rod 5. The temperature for heat treatment can be set in the range of 700 to 1200 °C, and the holding time is about 10 to 100 minutes.

The piezoelectric tube is finally produced by sintering the heat-treated sample at higher temperature of between 1100 and 1300 °C, for 1 to 3 hours, in an enriched atmosphere. In particular, the PZT material is an oxide and can be sintered in normal air environment, however, to reduce the loss of lead, which is a low melting point material, a lead enriched environment is preferred to ensure the described stoichiometry of the product.

In this example, the deposits are dried for 12 hours and then sintered in a programmable furnace at 1100 °C for 1 hour.

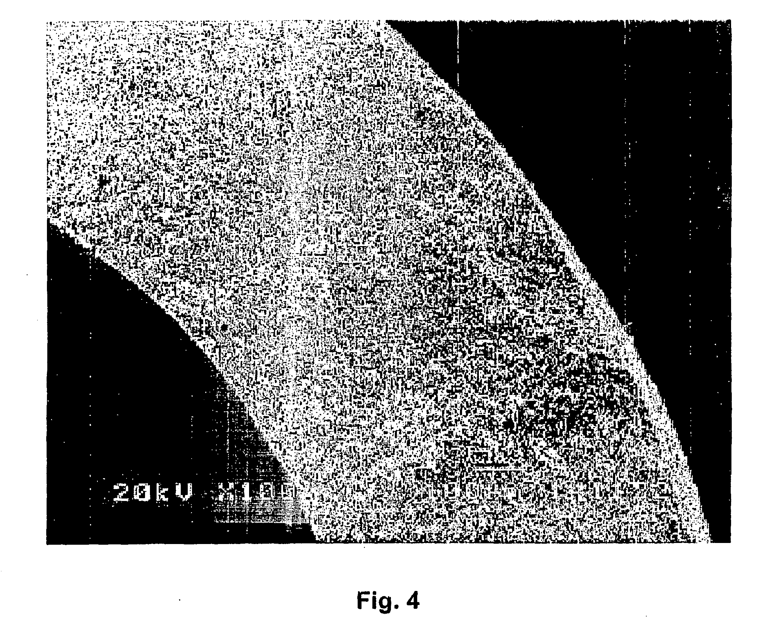

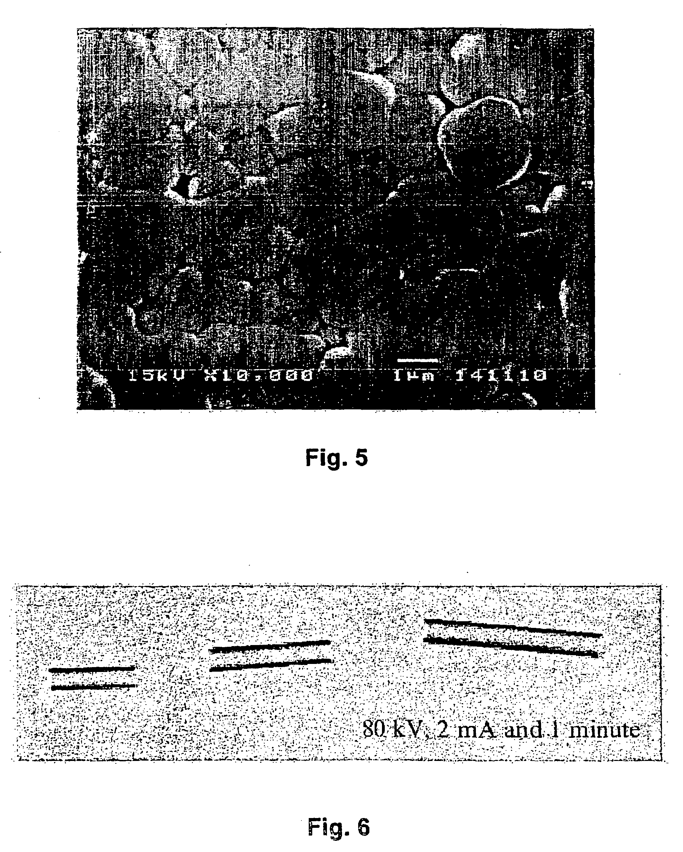

An example of a cross section through a resulting piezoelectric tube is shown in Figure 4. A second cross section at a higher magnification is shown in Figure 5, with X-ray photos of examples of different sized tubes being shown in Figure 6. The cross section in Figure 5 was obtained using an SEM micrograph of the sintered PZT tube. The sample was polished and then thermal etched at 1025°C for 15 minutes. It can be seen that the grain size was grown from around 1.4 $\mu$m to about 5 $\mu$m. The density of the tube was measured to be 7.54 g/cm$^3$ using an electronic densimeter, which is approximately 95% of the theoretical maximum value. This demonstrates that the density achieved using this technique is greatly improvement compared to other techniques such as the hydrothermal method.

The X-ray radiology photograph shown in Figure 6 also highlights that the structures reasonably uniform in diameter and wall thickness.

Thus, as shown, the tube has a substantially constant structure, and thickness, with no discontinuities, or other faults, thereby ensuring good material strength and durability, as well as ensuring consistency between different piezoelectric tubes produced using the method.

Accordingly, the process described above provides a technique for manufacturing piezoelectric tubes that may be used as actuators or transducers.

In order to be used as a transducer for piezoelectric pump, the sintered tube is cut into the designed length and brush-painted with silver paste to form inner and outer electrodes, before firing at 850°C for 20 minutes. Poling was next carried out in silicone oil at 100 °C by applying a DC field of 2 kV/mm along the radial thickness direction for 2 hours.

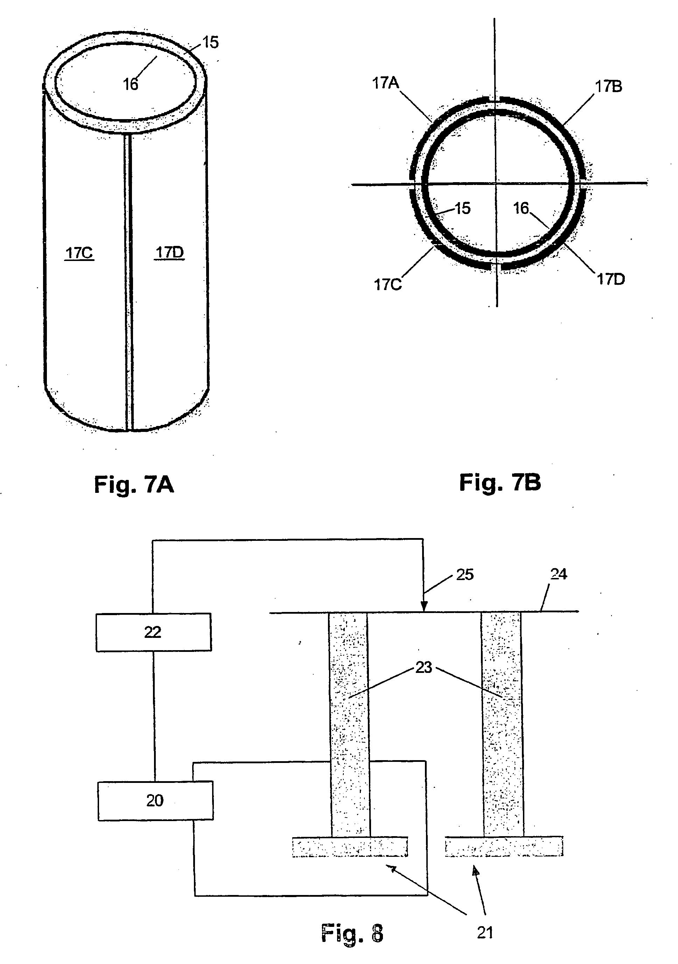

An example of a completed transducer is shown in Figures 7A and 7B. As shown the transducer includes a ceramic tube 15, a single inner electrode 16, and an outer electrode 17, having four quadrants 17A, 17B, 17C, 17D.

The process is simple, economical, and compact compared with other fabrication methods, thereby allowing piezoelectric transducers to be formed more rapidly, and reliably than using conventional techniques.

Another advantage is that the dimension of product can be adjusted and controlled in a wide range, which depends on the diameter selection of the conductive rod and the processing parameters (applied voltage, current, and deposition time).

Performance

The piezoelectric constant $d_{31}$ of a tubular transducer is given by the standard equations:

$$S_1 = d_{31}E_3 \tag{1}$$

where $S_1$ is the strain in the length direction of the tube given by:

$$S_1 = \frac{\Delta L}{L} \tag{2}$$

where $\Delta L$ and $L$ are transducer displacement and length respectively. $E_3$ is the average electric field, and this is given by:

$$E_3 = \frac{2V}{(r_o + r_i)\ln\frac{r_o}{r_i}} \tag{3}$$

where V is voltage added to the wall thickness direction; $r_o$ and $r_i$ are the outer and inner radius of the transducer respectively.

The displacement of the transducer can be measured using apparatus shown in Figure 8. In particular, the apparatus includes a ferroelectric test system 20, such as a Radiant Technologies, Inc. RT6000HVS, a vibraplane 21, a fotonic sensor 22, such as a probe MTI2032RX. MTI Instrument and the piezoelectric tube 23 assembled as shown.

The whole area of both the inner and outer surfaces of the piezoelectric tube was painted with silver paste to act as conducting electrodes. One end of the tube was fixed to the vibraplane 21 with epoxy in order to avoid any vibration-induced errors. The other end was attached with a reflection mark 24. The fotonic sensor probe 22 was targeted at the center of the mark as shown by arrow 25 and placed parallel to the longitudinal direction. During measurement, a bipolar step voltage was applied in the wall thickness direction of the tube 23 by the test system 20. The step voltage was increased from zero to maximum set voltage V, then decreased to negative maximum set voltage -V, and finally return to zero. The fotonic sensor then measured the displacement $\Delta L$ of the tube In response to the given voltage. 100 points were measured in a single voltage cycle.

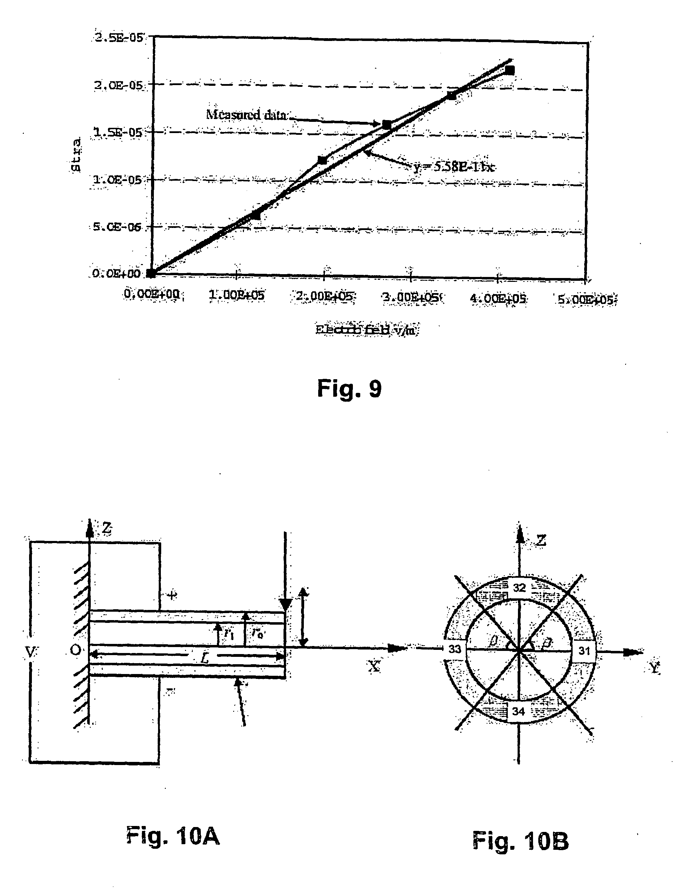

The measured displacement $\Delta L$ as a function of the set voltage V is shown in Figure 9, with the slope being defined using by equation.

$$y = 5.58 \times 10^{-11}x \tag{4}$$

The slope of $5.58 \times 10^{-11}$ provides the $d_{31}$ value of the material. This value indicates that the EPD technique can produce piezoelectric ceramic tubes ideally suited for use as a transducer, with the EPD technique having several other advantages over the traditional method such as the flexibility in component shape and ability to produce smaller component (<1 mm).

The bending displacement of the piezoelectric tube with clamped-free and free-free end conditions were derived and experimentally verified for the using apparatus similar to that shown above with respect to Figure 8. In this case, the coordinate system used for the derived equations is as shown in Figures 10A, and 10B. The origin O of the system lies at one end of the tube 23, as shown in Figure 10A. The neutral plane, X-Y plane, passes through the origin O. The transverse displacement takes place along the Z direction. As shown in Figure 10B, the electroded driving parts 32 and 34, and the unelectroded driven parts 31 and 33, are aligned mirror-symmetrically according to the Z-axis. Angle β, which determines the driving parts area, varies from 0 to 90°.

The tensile or compressive stress and strain along the longitudinal direction are denoted as T1 and S1 for the driving parts and T1' and S1' for the driven parts, respectively. According to the piezoelectric relationship, the stresses along the X-axis are expressed to be:

$$T_1 = \frac{1}{s_{11}^E} S_1 - \frac{d_{31}}{s_{11}^E} E_3 \tag{5}$$

$$T_1' = \frac{1}{s_{11}^E} S_1' \tag{6}$$

where $S_{11}^E$ is the elastic compliance constant. The electric field in thickness direction E3 is expressed as:

$$E_3 = \frac{V}{r \ln \frac{r_o}{r_i}} \tag{7}$$

where r is radius between outer radius $r_o$ and inner radius $r_i$.

Assuming that the cross section keeps plane under deflection, $S_1$ can be written as:

$$S_1 = -z \frac{1}{\rho} = -z \frac{dz^2}{dx^2} \tag{8}$$

where $\rho$ is the radius of curvature.

Finally, the bending moment of the a cross section at position x can be expressed as:

$$M = \int_{s1+s3} z T_1' \, ds + \int_{s2+s4} z T_1 \, ds \tag{9}$$

Putting Equation 5 to 8 into 9, gives:

$$M = -\frac{\pi}{4\rho s_{11}^E} \left( r_o^4 - r_i^4 \right) - \frac{2 d_{31} V}{s_{11}^E \ln \frac{r_o}{r_i}} \left( r_o^2 - r_i^2 \right) \cos \beta \tag{10}$$

Since in the static equilibrium condition the total bending moment over a cross section is zero, i.e., M = 0, this requires:

$$\frac{1}{\rho} = -\frac{8 d_{31} V \cos \beta}{\pi \left( r_o^2 + r_i^2 \right) \ln \frac{r_o}{r_i}} \tag{11}$$

As the radius of curvature keeps constant in the static situation, and since:

$$\frac{1}{\rho} = \frac{dz^2}{dx^2} \qquad\qquad (12)$$

it can be derived from Equation 4 that:

$$\frac{dz}{dx} = \frac{1}{\rho}x + C \qquad\qquad (13)$$

$$z = \frac{1}{2}\frac{1}{\rho}x^2 + Cx + D \qquad\qquad (14)$$

where C and D are constants.

The constant C and D can be determined by considering the clamped-free end, and the free-free end boundary conditions. In the clamped-free end boundary conditions:

$$\begin{cases} \dfrac{dz}{dx} = 0 \\ z = 0 \end{cases} \qquad\qquad (15)$$

it is obtained that C=D=0.

Thus, the maximum displacement at the free tip end is obtained to be:

$$\zeta = \frac{L^2}{2\rho} = -\frac{4d_{31}V\cos\beta L^2}{\pi\left(r_o^2 + r_i^2\right)\ln\dfrac{r_o}{r_i}} \qquad 0 < \beta < \frac{\pi}{2} \qquad\qquad (16)$$

The relation between the displacement $\zeta$ and piezoelectric constant $d_{31}$, angle $\beta$, voltage V and length L can then be obtained from Equation 16.

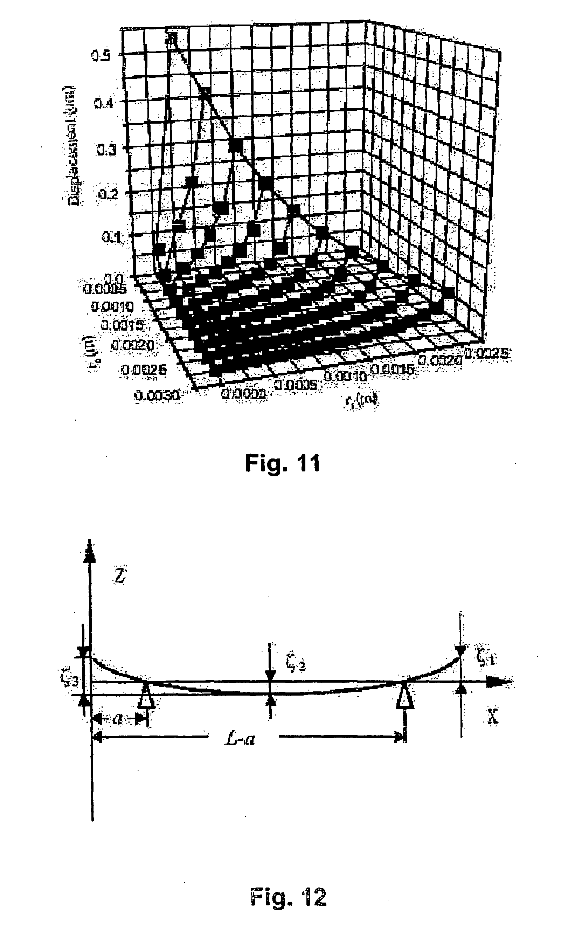

Figure 11 shows an illustration of the displacement with respect to changes of radius $r_o$ and $r_i$. The parameters used are $d_{31} = -4.5\times10^{-11}$ m/V, L=10 mm, $\beta$=45° and V=30V. The outer radius $r_o$ varies from 0.5 to 2.5 mm. The inner radius $r_i$ varies from near zero to 0.95 of the outer radius. It can be concluded from the present analysis that for the same outer radius, with increasing the inner radius, the displacement increases; and the larger the outer radius, the smaller the displacement for the same inner radius.

In the case of the free-free end boundary conditions, the transducer was supported at the two nodal points a and L-a as shown in Figure 12. The nodal point is the position where the displacement is zero at resonance frequency. Thus, following the same procedure as in clamped-free condition and using the boundary conditions:

$$\begin{cases} \dfrac{dz}{dx}\bigg|_{x<0.5L} = -\dfrac{dz}{dx}\bigg|_{L-x} \\ z = 0\big|_{x=a,L-a} \end{cases} \qquad\qquad (17)$$

The shape equation can be derived to be:

$$z = \frac{1}{2\rho}\left[\left(x - \frac{L}{2}\right)^2 - \left(a - \frac{L}{2}\right)^2\right]$$

$$(18)$$

Thus, the displacement can be calculated as:

$$\begin{cases} \zeta_1 = \frac{1}{2\rho} a(L-a) \\ \zeta_2 = -\frac{1}{2\rho}\left(a - \frac{L}{2}\right)^2 \\ \zeta_3 = \frac{L^2}{8\rho} \end{cases}$$

$$(19)$$

It can be seen that as the functional displacement $\zeta_1$ is reduced, the total deflection $\zeta_3$ is equal to one quarter of the tip displacement in clamped-free condition. As a result, the clamped-free end condition is a better design to be used for the motor in terms of displacement. This has also offered method for miniaturization of the functional transducer since a clamped-free transducer provides larger displacement for the same size. In addition, the clamped-free end condition tube has lower resonant frequency compared with free-free configuration tube.

In order to verify the above-derived equations, the end displacement of the clamped-free transducer was measured. The transducer set up and the measurement procedure is the same as that is used for $d_{31}$ measurement shown in Figure 10A. However, the outer electrode is divided into 4 parts, and the angle $\beta$ is equal to 45°.

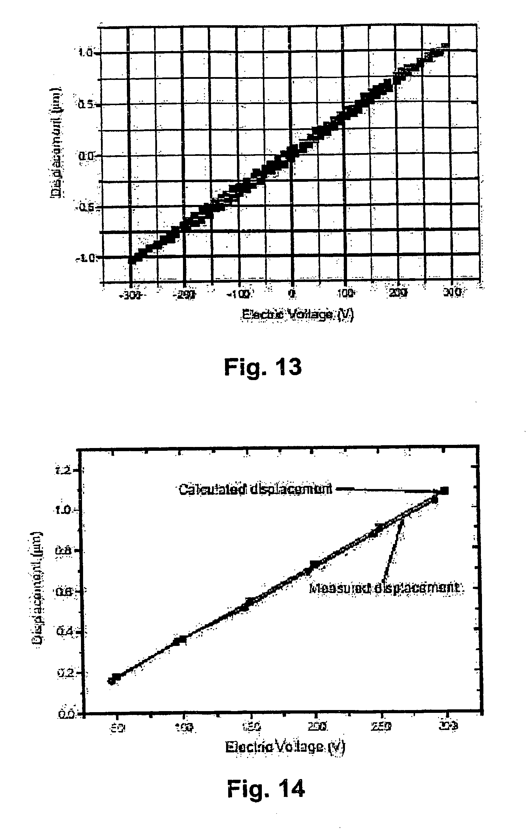

Figure 13 shows one cycle of the displacement in response to the step voltage under a given set value 300 V. A good linear property with small hysteresis is clearly shown for a typical hard material. Figure 14 shows the comparison of the measured results and the calculated results using Equation 16 for the displacement under 300 V. The applied parameters are tabulated in Table 1, below.

Table 1

| Outer radius $r_o$ (mm) | Inner radius $r_i$ (mm) | Length L (mm) | Angle $\beta°$ | $d_{31}$ ($10^{-11}$ m/V) |
|---|---|---|---|---|
| 1.45 | 1.19 | 9.98 | 45 | -5.58 |

It can be seen that the calculated value is in good agreement with the measured results.

Accordingly electropheretic deposition is shown to be a good method to fabricate small, dense buik piezoelectric tube with desired perovskite phase and fine microstructure to be used as tubular transducer. The static bending displacement with clamped-free and free-free end conditions have indicated that:

The bending displacement is proportional to the piezoelectric constant d31, the voltage V added in the thickness direction, the square of transducer length L and cosβ (0<β<π/2);

At a given outer radius, the displacement increases with increase of the inner radius; the larger the outer radius, the smaller the displacement for the same inner radius;

The transverse displacement will decrease when the boundary conditions changes from clamped-free to free-free.

This makes the resultant tubes ideal for use as transducer, for example for use in a pump.

Second Specific Example

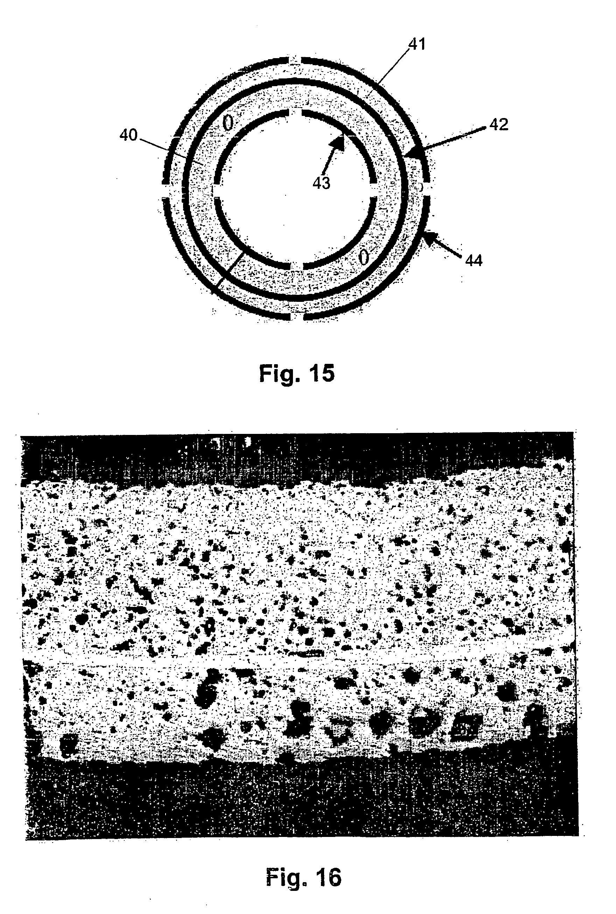

In the case in which the produced piezoelectric tubes are used in STMs or as transducers in piezoelectric motors, large displacement is desirable to achieve a larger scanning range or higher rotational speed and torque, respectively. This can be achieved using a double-layered tubular transducer, an example of which is shown in Figure 15. In this example the double-layered transducer includes first and second ceramic layers 40, 41 separated by an intermediate electrode 42 inner and outer electrodes 43, 44 are also provided and are sectioned Into quadrants as shown. The fabrication process is substantially similar to that described above with respect to the single layer transducer, and will not therefore be described in detail.

In particular, the first ceramic layer is deposited on the rod 5, as described above. The deposited layer is dried thoroughly, and then painted with uniform platinum paste before a second layer of deposition is performed. In this case, the EDP current may be applied to the rod or the platinum paste layer, depending on the implementation. After drying for 12 hours, the dual deposit layers are sintered in a programmable furnace at 1100°C for 1 hour.

The sintered tube was then cut into the designed length and painted with silver paste as the inner and outer electrodes before firing at 850°C for 20 minutes. Poling was next carried out in silicone oil at 100°C by applying a DC field of 2 kV/mm along the radial thickness direction for 2 hours.

Figure 16 shows a segment of the cross section of the piezoelectric tube after sintering, observed using an optical microscope. It can be seen that a reasonably fine and narrow platinum intermediate electrode about 12 $\mu$m separates the two layers. It also demonstrates that EPD is an effective technique to fabricate the double-layered structure. In Figure 16, the electrode is designed to position near the outer surface. By varying the parameters of electrophoretic deposition, the location of the electrode can be adjusted, as will be appreciated by persons skilled in the art.

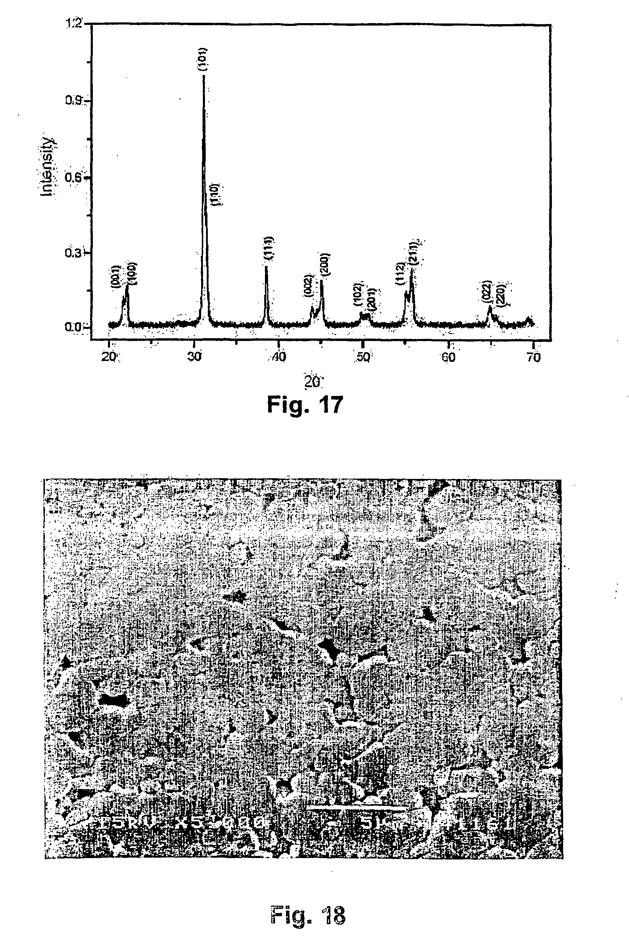

To confirm the composition of the deposited piezoelectric PZT tubes, an XRD measurement was carried out using a Shimadzu XRD-6000 with Cu target under 50.0 kV, 20.0 mA and 2.0000 deg/min scanning speed. Figure 17 illustrates the XRD pattern of the materials after sintering, and the expected tetragonal-phase perovskite structure of PZT was observed.

Figure 18 shows an SEM micrograph of cross section of the piezoelectric tube. The average grain size is evaluated to be approximately 2.6 $\mu$m. Some residual pores were also observed. The density is measured to be 7.639 g/cm$^3$ using an electronic densimeter (MD-200s), which is 96.7% of the theoretical value. The results have shown that the piezoelectric tube has been sintered to a relatively dense state.

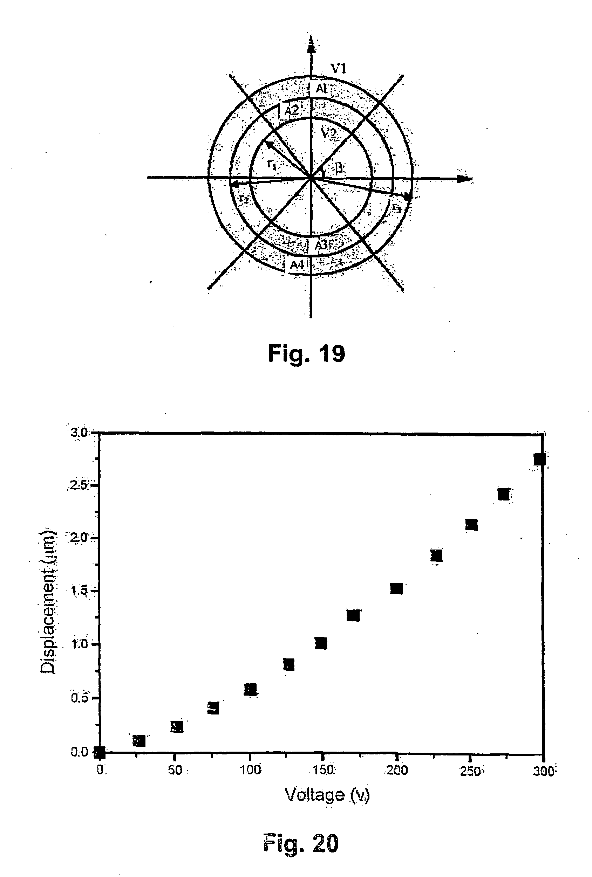

Figure 19 illustrates the cross section layout of the double-layered tubular transducer. In use, the intermediate electrode $r_2$ is grounded. The areas A1 to A4 are the driving parts. They are applied with voltage V1 and V2, respectively. In both designs, angle $\beta$ determines the driving area of the transducer.

Deriving equations in a manner similar to that described above, the bending displacement of the double-layered transducer under Clamped-Free boundary condition is:

$$\zeta = -\frac{4d_{31}V_1(r_3^2 - r_2^2)\cos\beta L^2}{\pi(r_3^4 - r_1^4)(\ln r_3 - \ln r_2)} - \frac{4d_{31}V_2(r_2^2 - r_1^2)\cos\beta L^2}{\pi(r_3^4 - r_1^4)(\ln r_2 - \ln r_1)} \qquad 0 \le \beta \le \frac{\pi}{2} \tag{20}$$

The relation between the displacement $\zeta$ and piezoelectric constant $d_{31}$, angle $\beta$, voltage V (V1 and V2), length L, inner radius $r_1$, intermediate radius $r_2$ and outer radius $r_3$ can be easily obtained from the equations.

A tubular transducer with dimensions listed in Table 2 below was used to measure the bending displacement.

Table 2

| L (mm) | $r_1$ (mm) | $r_2$ (mm) | $r_3$ (mm) | $\beta$ (Degree) |
|---|---|---|---|---|
| 12.08 | 1.61 | 1.78 | 1.87 | 0 |

The intermediate radius $r_2$ was measured under optical microscope. The apparatus used for displacement measurement is similar to that described above and will not be described in detail.

Figure 20 shows the longitudinal displacement under different voltages. A perfect straight line was not observed as expected. This is because the material is not hard enough to keep linear properties under high electric field and hence displays certain not-linearity. The maximum electric field is estimated to be more than 1150 V/mm at 300 V. However, since the displacement is basically a straight line when the applied voltage is below 100 V, the data below this voltage were applied to determine $d_{31}$ using the standard relationship

$$S_1 = d_{31}E_3 \tag{21}$$

Applying Equation (3), $d_{31}$ is calculated to be $1.18\times1010$ mN.

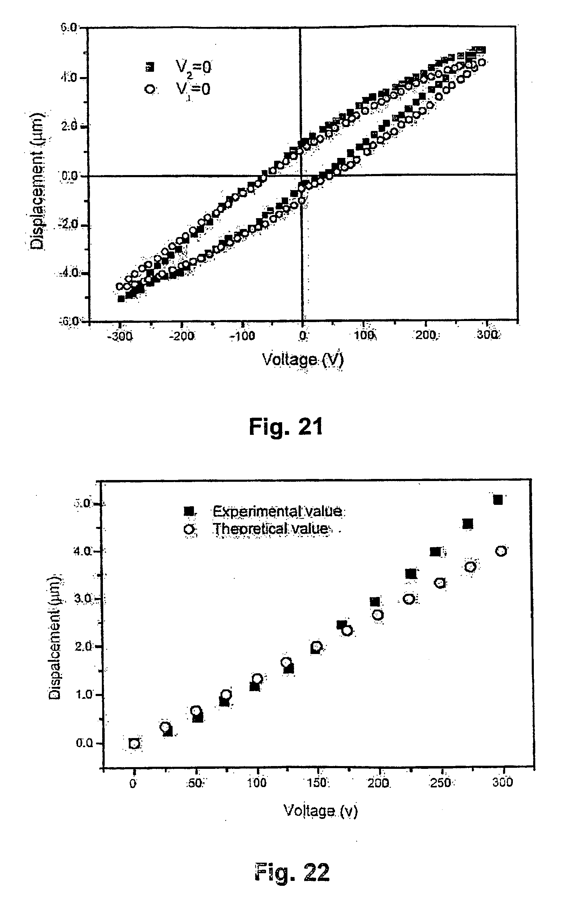

The bending displacements for two situations, $V_1=0$ and $V_2=0$, in Equation (20) were also measured experimentally. Figure 21 shows one cycle of the displacement in response to the step voltage under a maximum applied voltage of 300 V ($V_1$=0, $V_2$=300; V2=0, V1=300). Both curves have shown low electromechanical loss, which is caused by the domain wall motion. As shown the resulting hysteresis is small.

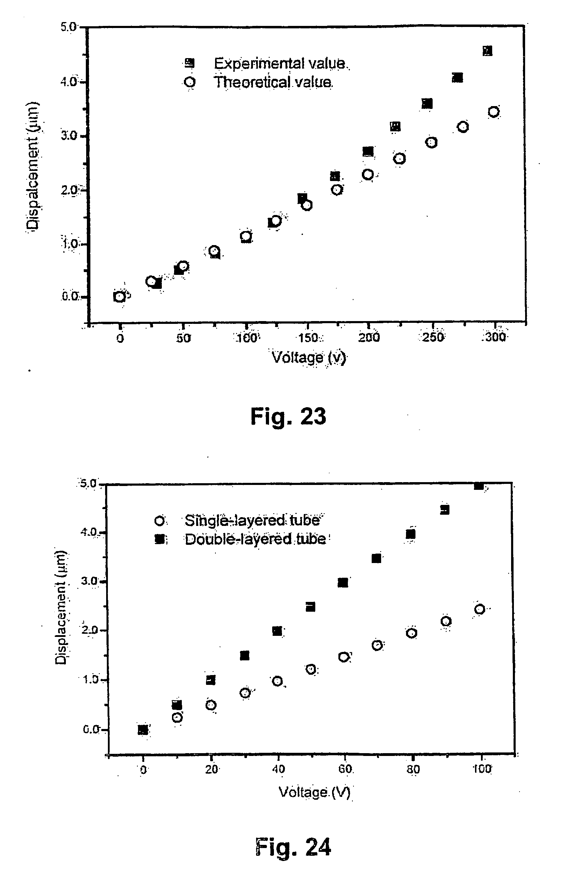

Figures 22 and 23 show the comparison between the theoretical and experimental value for the two conditions $V_1$=0 and $V_2$=0, respectively. These two figures show the same trend as that observed in Figure 20, i.e., in the lower voltage range, the experimental value keeps basically good consistency with the theoretical value. However as the voltage goes up to 300 V, the material exhibits strong non-linearity and the deviation between the theoretical predictions and the experimental measurements becomes large.

The bending displacement between the double-layered system and the single-layered system can be compared using equations (16) and (20). Figure 24 shows the theoretical bending predictions of the two systems. It is found that the bending displacement can be significantly increased if the double-layered system is applied. The enhancement is approximately doubled under the same driving voltage.

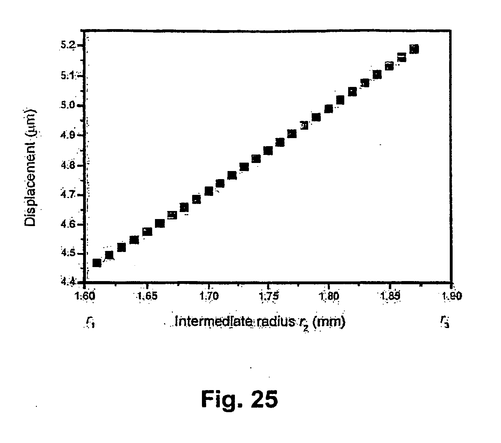

Figure 25 shows an illustration of the displacement with respect to changes in intermediate radius $r_2$. It can be found that the displacement increase linearly when $r_1$ increases to $r_3$. The maximum enhancement is measured to be 16%. As a result, it is also shown that the bending displacement can also be increased by increasing the intermediate radius $r_2$ for a same transducer dimensions.

Accordingly Electrophoretic Deposition has been shown to be a good method to fabricate double-layered piezoelectric tubular transducer. The bending displacement of the double-layered tubular transducer was found to be in good agreement with the theoretical predictions within the linear range and much larger than bending displacement obtainable with a single layer transducer.

It will be appreciated that the technique can be further extended to provide multi-layered tubes having N layers (where N>2), with the multi-layered tubes having even further enhanced bending displacement properties.

## Claims

1. An apparatus for forming a piezoelectric element, the apparatus including:

   (a) a container (4) for containing a suspension (1) of ceramic particles (2) in a fluid medium (3);
   (b) a substrate (5) in contact with the fluid medium (3);
   (c) an electrode (6) in contact with the fluid medium (3);
   (d) a power supply (7) adapted to apply a predetermined voltage between the substrate (5) and the electrode (6) to thereby deposit at least some of the particles (2) on the substrate (5) in use; and,
   (e) a heat source for heat-treating the deposited particles to form the piezoelectric element,

   **characterised in that** the piezoelectric element is a piezoelectric tube and the substrate is a rod (5) to which the power supply (7) applies the predetermined voltage; and,
   further **characterised in that** the heat source is adapted to:

   (i) heat the deposited particles to a first predetermined temperature to thereby solidify the particles to a surface of the rod and burn off the rod (5), to thereby leave a tube of solidified particles (14), the tube being closed at one end (14A); and,
   (ii) heat the tube (14) to a second predetermined temperature to thereby sinter the tube (14) to form a dense ceramic tube.

2. The apparatus according to claim 1, further including a painter for supplying a metal paste to an outer surface of a first layer formed from the deposited particles.

3. The apparatus according to claim 1 or claim 2, the container (4) being a conductive container adapted to act as the electrode.

4. The apparatus according to claim 3, the container (4) being formed from at least one of stainless steel, copper, and another metal.

5. The apparatus according to claim 3, the container (4) being formed from at least one of glass and plastic, the container being coated with at least one conductive layer.

6. The apparatus according to claim 1, the second predetermined temperature being higher than the first predetermined temperature.

7.  The apparatus according to claim 1, the first predetermined temperature being between 500 and 1200°C.

8.  The apparatus according to claim 1, the second predetermined temperature being between 850 and 1300°C.

9.  The apparatus according to any one of claims 1 to 8, the rod (5) being formed from graphite.

10. The apparatus according to any one of claims 1 to 8, the rod (5) being formed from at least one of plastic and another material that can be burnt off at the first predetermined temperature, the rod being coated with at least one conductive layer.

11. The apparatus according to any one of claims 1 to 10, the apparatus further including a magnetic stirrer (12) for stirring the fluid medium (3) to prevent sedimentation of the particles (2) in the suspension (1).

12. A method of forming a piezoelectric element, the method including the steps of:

> (a) forming a suspension (1) of ceramic particles (2) in a fluid medium (3);
> (b) positioning a substrate (5) in the fluid medium (3);
> (c) depositing particles (2) on the substrate (5) by electrophoresis; and,
> (d) heat-treating the deposited particles to form the piezoelectric element,

> **characterised in that** the piezoelectric element is a piezoelectric tube and the substrate is a rod (5); and,
> further **characterised in that** the method of heat-treating the deposited particles includes:

> (i) heating the deposited particles to a first predetermined temperature to thereby solidify the particles to a surface of the rod (5) and burn the rod (5), to thereby leave a tube (14) of solidified particles, the tube being closed at one end (14A); and,
> (ii) heating the tube (14) to a second predetermined temperature to thereby sinter the tube to form a dense ceramic tube.

**Patentansprüche**

1.  Vorrichtung zur Bildung eines piezoelektrischen Elements, wobei die Vorrichtung umfasst:

> (a) einen Behälter (4) zum Aufnehmen einer Suspension (1) keramischer Teilchen (2) in einem fluiden Medium (3);
> (b) ein Substrat (5) in Kontakt mit dem fluiden Medium (3);
> (c) eine Elektrode (6) in Kontakt mit dem fluiden Medium (3);
> (d) eine Stromversorgung (7), die angepasst ist, eine vorbestimmte Spannung zwischen dem Substrat (5) und der Elektrode (6) anzulegen, um **dadurch** zumindest einige der Teilchen (2) auf das in Gebrauch befindliche Substrat (5) abzuscheiden; und,
> (e) eine Wärmequelle zur Wärmebehandlung der abgeschiedenen Teilchen, um das piezoelektrische Element zu bilden,

> **dadurch gekennzeichnet, dass** das piezoelektrische Element eine piezoelektrische Röhre ist und das Substrat eine Stange (5) ist, an welche die Stromversorgung (7) die vorbestimmte Spannung anlegt; und
> weiter **dadurch gekennzeichnet, dass** die Wärmequelle angepasst ist:

> (i) die abgeschiedenen Teilchen auf eine erste vorbestimmte Temperatur zu erwärmen, um **dadurch** die Teilchen auf einer Oberfläche der Stange zu verfestigen und die Stange (5) wegzubrennen, um **dadurch** eine Röhre verfestigter Teilchen (14) zurückzulassen, wobei die Röhre an einem Ende (14A) geschlossen ist; und
> (ii) die Röhre (14) auf eine zweite vorbestimmte Temperatur zu erwärmen, um **dadurch** die Röhre (14) zu sintern, um eine dichte Keramikröhre zu bilden.

2.  Vorrichtung nach Anspruch 1, die weiter eine Lackiervorrichtung zum Liefern einer Metallpaste auf eine Außenfläche einer ersten Schicht umfasst, die aus den abgeschiedenen Teilchen gebildet ist.

3. Vorrichtung nach Anspruch 1 oder Anspruch 2, wobei der Behälter (4) ein leitfähiger Behälter ist, der angepasst ist, als die Elektrode zu fungieren.

4. Vorrichtung nach Anspruch 3, wobei der Behälter (4) aus zumindest einem Edelstahlmetall, Kupfermetall und noch einem Metall gebildet ist.

5. Vorrichtung nach Anspruch 3, wobei der Behälter (4) aus zumindest einem von Glas und Kunststoff gebildet ist, wobei der Behälter mit zumindest einer leitfähigen Schicht beschichtet ist.

6. Vorrichtung nach Anspruch 1, wobei die zweite vorbestimmte Temperatur höher als die erste vorbestimmte Temperatur ist.

7. Vorrichtung nach Anspruch 1, wobei die erste vorbestimmte Temperatur zwischen 500 und 1200 °C liegt.

8. Vorrichtung nach Anspruch 1, wobei die zweite vorbestimmte Temperatur zwischen 850 und 1300 °C liegt.

9. Vorrichtung nach einem beliebigen der Ansprüche 1 bis 8, wobei die Stange (5) aus Grafit gebildet ist.

10. Vorrichtung nach einem beliebigen der Ansprüche 1 bis 8, wobei die Stange (5) aus zumindest einem von Kunststoff und noch einem Material gebildet ist, das bei der ersten vorbestimmten Temperatur weggebrannt werden kann, wobei die Stange mit zumindest einer leitfähigen Schicht beschichtet ist.

11. Vorrichtung nach einem beliebigen der Ansprüche 1 bis 10, wobei die Vorrichtung weiter einen magnetischen Rührer (12) zum Rühren des fluiden Mediums (3) umfasst, um Sedimentation der Teilchen (2) in der Suspension (1) zu verhindern.

12. Verfahren zur Bildung eines piezoelektrischen Elements, wobei das Verfahren folgende Schritte umfasst:

(a) Bilden einer Suspension (1) keramischer Teilchen (2) in einem fluiden Medium (3);
(b) Positionieren eines Substrats (5) im fluiden Medium (3);
(c) Abscheiden von Teilchen (2) auf das Substrat (5) durch Elektrophorese; und
(d) Wärmebehandlung der abgeschiedenen Teilchen, um das piezoelektrische Element zu bilden,

**dadurch gekennzeichnet, dass** das piezoelektrische Element eine piezoelektrische Röhre ist und das Substrat eine Stange (5) ist; und
weiter **dadurch gekennzeichnet, dass** das Wärmebehandlungsverfahren der abgeschiedenen Teilchen umfasst:

(i) Erwärmen der abgeschiedenen Teilchen auf eine erste vorbestimmte Temperatur, um **dadurch** die Teilchen auf einer Oberfläche der Stange (5) zu verfestigen und die Stange (5) zu verbrennen, um **dadurch** eine Röhre (14) verfestigter Teilchen zurückzulassen, wobei die Röhre an einem Ende (14A) geschlossen ist; und
(ii) Erwärmen der Röhre (14) auf eine zweite vorbestimmte Temperatur, um **dadurch** die Röhre zu sintern, um eine dichte Keramikröhre zu bilden.

**Revendications**

1. Appareil de formation d'un élément piézo-électrique, l'appareil comportant :

(a) un contenant (4) pour contenir une suspension (1) de particules céramique (2) dans un milieu fluide (3) ;
(b) un substrat (5) en contact avec le milieu fluide (3) ;
(c) une électrode (6) en contact avec le milieu fluide (3) ;
(d) une alimentation électrique (7) conçue pour appliquer une tension prédéterminée entre le substrat (5) et l'électrode (6) afin de déposer ainsi au moins quelques-unes des particules (2) sur le substrat (5) en utilisation ; et
(e) une source de chaleur pour soumettre les particules traitées à un traitement thermique afin de former l'élément piézo-électrique,

**caractérisé en ce que** l'élément piézo-électrique est un tube piézo-électrique et le substrat est une tige (5) à laquelle l'alimentation électrique (7) applique la tension prédéterminée ; et

**caractérisé en outre en ce que** la source de chaleur est conçue pour :

(i) chauffer les particules déposées jusqu'à une première température prédéterminée afin de solidifier ainsi les particules sur une surface de la tige et de calciner la tige (5), afin de laisser ainsi un tube de particules solidifiées (14), le tube étant fermé à une extrémité (14A) ; et
(ii) chauffer le tube (14) jusqu'à une deuxième température prédéterminée pour fritter ainsi le tube (14) afin de former un tube céramique dense.

2. Appareil selon la revendication 1, comportant en outre un poste de peinture pour fournir une pâte métallique sur une surface externe d'une première couche qui a été formée à partir des particules déposées.

3. Appareil selon la revendication 1 ou la revendication 2, le contenant (4) étant un contenant conducteur conçu pour jouer le rôle d'électrode.

4. Appareil selon la revendication 3, le contenant (4) étant formé à partir de l'une au moins des substances suivantes, à savoir : acier inoxydable, cuivre et un autre métal.

5. Appareil selon la revendication 3, le contenant (4) étant formé à partir de l'une au moins des substances suivantes, à savoir : verre et matière plastique, le contenant étant revêtu d'au moins une couche conductrice.

6. Appareil selon la revendication 1, la deuxième température prédéterminée étant supérieure à la première température prédéterminée.

7. Appareil selon la revendication 1, la première température prédéterminée se situant entre 500 et 1200°C.

8. Appareil selon la revendication 1, la deuxième température prédéterminée se situant entre 850 et 1300°C.

9. Appareil selon l'une quelconque des revendications 1 à 8, la tige (5) étant formée à partir de graphite.

10. Appareil selon l'une quelconque des revendications 1 à 8, la tige (5) étant formée à partir de l'une au moins des substances suivantes, à savoir : matière plastique et un autre matériau apte à être calcinés à la première température prédéterminée, la tige étant revêtue d'au moins une couche conductrice.

11. Appareil selon l'une quelconque des revendications 1 à 10, l'appareil comportant en outre un agitateur magnétique (12) pour assurer l'agitation du milieu fluide (3) afin d'empêcher la sédimentation des particules (2) présentes dans la suspension (1).

12. Procédé de formation d'un élément piézo-électrique, le procédé englobant les étapes consistant à :

(a) préparer une suspension (1) de particules céramique (2) dans un milieu fluide (3) ;
(b) positionner un substrat (5) dans le milieu fluide (3) ;
(c) faire déposer des particules (2) sur le substrat (5) grâce à un processus d'électrophorèse ; et
(d) soumettre les particules déposées à un traitement thermique pour former l'élément piézo-électrique,

**caractérisé en ce que** l'élément piézo-électrique est un tube piézo-électrique et le substrat est une tige (5) ; et
**caractérisé en outre en ce que** le procédé utilisé pour soumettre les particules déposées à un traitement thermique comporte les opérations consistant à :

(i) chauffer les particules déposées jusqu'à une première température prédéterminée afin de solidifier ainsi les particules sur une surface de la tige (5) et de calciner la tige (5), afin de laisser ainsi un tube (14) de particules solidifiées, le tube étant fermé à une extrémité (14A) ; et
(ii) chauffer le tube (14) jusqu'à une deuxième température prédéterminée pour fritter ainsi le tube afin de former un tube céramique dense.

**Fig. 1**

**Fig. 2**

**Fig. 3**

Fig. 4

**Fig. 5**

80 kV, 2 mA and 1 minute

**Fig. 6**

**Fig. 7A**

**Fig. 7B**

**Fig. 8**

**Fig. 9**

**Fig. 10A**

**Fig. 10B**

**Fig. 11**

**Fig. 12**

**Fig. 13**

**Fig. 14**

**Fig. 15**

**Fig. 16**

**Fig. 17**

**Fig. 18**

Fig. 19

Fig. 20

**Fig. 21**

**Fig. 22**

**Fig. 23**

**Fig. 24**

**Fig. 25**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 8336967 A
- US 20020024270 A1
- US 6349455 B1
- WO 60415844 A

### Non-patent literature cited in the description

- **BINNING ; SMITH.** Single-tube three-dimensional scanner from scanning tunneling microscopy. *Rev Sci. Instrum.,* vol. 57, 1688-1989
- **Higuchi et al.** An ultrasonic micromotor using a bending cylindrical transducer based on PZT thin film. *Sensors and Actuators A,* 1995, vol. 50, 75-80
- A Cylindrical Micro Ultrasonic Motor Using PZT Thin Film Deposited by Single Process Hydrothermal Method (φ 2.4mm, L=10 mm Stator Transducer). *IEEE Transactions on Ultrasonics, Ferroelectrics, and Frequency Control,* 1998, vol. 45 (5), 1178-1187
- **Higuchi et al.** *IEEE Ultrasonics Symposium,* 1994, vol. 549